# EUROPÄISCHE PATENTSCHRIFT

(11) **EP 0 857 542 B1**
(45) Veröffentlichungstag und Bekanntmachung des Hinweises auf die Patenterteilung: **12.12.2001**
(21) Anmeldenummer: 98101959.9
(22) Anmeldetag: 05.02.1998
(51) Int. Cl.: B24B 37/04, H01L 21/304, H01L 21/20

(54) **Verfahren zur Herstellung einer einseitig beschichteten und mit einem Finish versehenen Halbleiterscheibe**
Method of making a single side coated and final mirror polished wafer
Méthode pour fabrication d'une plaquette semi-conductrice à une seule face et avec finition miroir

(30) Priorität: 06.02.1997 DE 19704546
(43) Veröffentlichungstag der Anmeldung: 12.08.1998
(73) Patentinhaber: Wacker Siltronic Gesellschaft für Halbleitermaterialien Aktiengesellschaft, 84489 Burghausen (DE)
(72) Erfinder: Pietsch, Georg, Dr., 84489 Burghausen (DE); Sauter, Bernd, Dr., 84547 Emmerting (DE); Feuchtinger, Ernst, 84384 Wittibreut (DE)

(56) Entgegenhaltungen:
- US-A- 4 888 304
- US-A- 4 983 251
- US-A- 5 389 579
- US-A- 5 643 405

## Beschreibung

Gegenstand der Erfindung ist ein Verfahren zur Herstellung einer einseitig beschichteten und mit einem Finish versehenen Halbleiterscheibe. Unter einer ein Finish auf einer Halbleiterscheibe erzeugenden Behandlung versteht man eine materialabtragende Behandlung, durch die die Formgebung der Halbleiterscheibe im wesentlichen abgeschlossen wird und die zum Ziel hat, die Oberfläche der Halbleiterscheibe, insbesondere die beiden Seiten der Halbleiterscheibe, in einen besonders ebenen, glatten und defektfreien Zustand zu versetzen. Eine derartige Behandlung ist unbedingt notwendig, um der Halbleiterscheibe die für eine Weiterverarbeitung zu hochintegrierten elektronischen Bauelementen geforderten Eigenschaften zu geben. Die wichtigsten, ein Finish auf den Seiten einer Halbleiterscheibe erzeugenden Behandlungsmethoden umfassen materialabtragende Methoden, wie das chemisch-mechanische Polieren und das Feinschleifen. In beiden Fällen werden Bearbeitungswerkzeuge mit rotierenden Arbeitsflächen eingesetzt, die auf eine oder beide Seiten einer Halbleiterscheibe einwirken, wobei ein bestimmter Materialabtrag erzeugt wird. Bei der chemisch-mechanischen Politur bewirken ein Poliermittel und ein Poliertuch, das über die Arbeitsfläche des Bearbeitungswerkzeugs (Polierteller) gespannt ist, den Materialabtrag. Beim Feinschleifen ist die Arbeitsfläche des Bearbeitungswerkzeugs mit Disken belegt, die eine materialabtragende Schicht von gebundenem, feinem Schleifpulver aufweisen. Da jede Halbleiterscheibe eine Vorder- und eine Rückseite besitzt, wird zwischen einer Einseiten-Behandlung und einer Doppelseiten-Behandlung unterschieden. Dieser Unterschied wird nachfolgend am Beispiel der Politur erläutert.

Bei der Einseiten-Politur ("single side polishing", SSP) wird nach Montage der Rückseite der Halbleiterscheibe auf einen geeigneten Träger nur die Vorderseite der Halbleiterscheibe mit einem auf einen Polierteller gespannten Poliertuch poliert. Bei der Montage wird zwischen der Rückseite und dem Träger eine form- und kraftschlüssige Verbindung, beispielsweise durch Adhäsion ("template polishing"), Kleben, Kitten oder Vakuumanwendung, hergestellt. Einseiten-Polierverfahren und - Vorrichtungen sind für die Einzelscheiben-Behandlung ("single wafer polishing") oder für die Behandlung von Gruppen von Scheiben ("batch polishing") üblich. Bei der Doppelseiten-Politur ("double side polishing", DSP) werden Vorderseite und Rückseite der Halbleiterscheibe gleichzeitig poliert, indem mehrere Halbleiterscheiben zwischen zwei mit Poliertüchern bespannten, oberen und unteren Poliertellern geführt werden. Dabei liegen die Halbleiterscheiben in dünnen Führungskäfigen ("wafer carrier"), die als Läuferscheiben bezeichnet werden und in ähnlicher Form auch beim Läppen von Halbleiterscheiben verwendet werden. Doppelseiten-Polierverfahren und -Vorrichtungen sind stets für die Behandlung von Gruppen von Halbleiterscheiben ausgelegt ("batch polishing").

Eine beidseitig polierte Halbleiterscheibe weist gegenüber einer nur einseitig polierten Halbleiterscheibe sehr viel weniger störende Partikel auf, sie ist einfacher zu reinigen und weniger anfällig für Kontaminationen, und schließlich ist auch ihre metrologische Meß-, Charakterisier- und Spezifizierbarkeit einfacher.

In der US-5,389,579 ist ein Verfahren beschrieben, das aufzeigt, wie eine einseitig polierte Halbleiterscheibe durch Doppelseiten-Politur hergestellt werden kann.

Grundsätzlich kann eine beidseitig polierte Halbleiterscheibe hergestellt werden, indem mit einem Einseiten-Polierverfahren nacheinander die Vorder- und Rückseite poliert werden (sequentielle SSP). überwiegend verwendetes Verfahren zum Erzielen einer Politur beider Seiten einer Halbleiterscheibe ist jedoch die Doppelseiten-Politur. Die Vorteile der DSP gegenüber der sequentiellen SSP bestehen in dem überlegenen Grad der erzielbaren Ebenheit und Planparallelität der Seiten, der kostengünstigeren Duchführbarkeit der Politur sowie dem höheren Durchsatz und der höheren Ausbeute infolge des Fortfalls der bei der sequentiellen SSP notwendigen Montage-, Demontage und Wendeschritte.

Eine der Unterscheidung zwischen SSP und DSP entsprechende Differenzierung läßt sich auch in Bezug auf das Feinschleifen vornehmen. Auch in diesem Fall ist es zutreffend, daß das Ergebnis eines einseitig vorgenommenenen Feinschliffes, auch wenn beide Seiten einer Halbleiterscheibe nacheinander geschliffen werden, dem Ergebnis eines doppelseitig erfolgenden Feinschliffes unterlegen ist. Nachfolgend wird der Begriff "Doppelseiten-Behandlung" als Oberbegriff für materialabtragende und ein Doppelseiten-Finish erzeugende Behandlungen einer Halbleiterscheibe verwendet, die wie die Doppelseiten-Politur oder der Doppelseiten-Feinschliff geeignet sind, eine Halbleiterscheibe mit besonders ebenen, planparallelen, glatten und defektfreien Seiten zu versehen. Derartige Doppelseiten-Behandlungen haben gemeinsam, daß die Halbleiterscheibe zwischen rotierende Arbeitsflächen eines Bearbeitungswerkzeugs gebracht wird und mit dessen Unterstützung Material von den Seiten der Halbleiterscheibe abgetragen wird.

Jede Handhabung einer bereits polierten oder feingeschliffenen Halbleiterscheibe mit einem mechanisch einwirkenden Handhabungswerkzeug, beispielsweise einem Greifer ("handler"), birgt die Gefahr der Schädigung der polierten oder feingeschliffenen Scheibenoberfläche, beispielsweise dadurch, daß Abdrücke oder Kratzer erzeugt werden. Besonders kritisch sind solche Schädigungen, die die Seite der Halbleiterscheibe betreffen, auf der die Unterbringung elektronischer Bauelemente vorgesehen ist. Andererseits gibt es eine Reihe von Anwendungen, bei denen eine Seite der Halbleiterscheibe mindestens einmal beschichtet werden muß. Dieser Vorgang ist dann zwangsläufig mit dem Risiko der mechanischen Beschädigung der gegenüberliegenden Seite verbunden.

In der EP-607 940 A2 ist ein Verfahren beschrieben, bei dem zuerst auf der Rückseite einer Halbleiterscheibe eine diese Seite schützende Schicht erzeugt wird und anschließend die gegenüberliegende Vorderseite der Halbleiterscheibe poliert wird. Das zeitliche Vorziehen einer einseitigen Beschichtung vor eine Einseiten-Politur hat jedoch Nachteile. So ist eine Einseiten-Politur einer Doppelseiten-Politur bezüglich der erzielbaren Ebenheit und Planparallelität der Seiten unterlegen. Besonders nachteilig ist, daß die Oberfläche der zur Beschichtung vorgesehenen Seite, deren Ebenheit noch unzulänglich ist, durch eine der Politur zeitlich vorgezogene Beschichtung begraben und konserviert wird. Eine nachfolgende Einseiten-Politur kann diesen Mangel nicht beseitigen.

Die vorliegende Erfindung löst das Problem, Halbleiterscheiben bereitzustellen, deren Eigenschaften in Bezug auf Ebenheit, Planparallelität, Glattheit und Defektfreiheit der Seiten trotz des Vorhandensseins einer einseitigen Beschichtung vergleichbar sind mit denen von Halbleiterscheiben, die mit einem Doppelseiten-Finish versehen sind und eine solche Beschichtung nicht aufweisen.

Gegenstand der Erfindung ist ein Verfahren zur Herstellung einer einseitig beschichteten und mit einem Finish versehenen Halbleiterscheibe, das dadurch gekennzeichnet ist, daß
a) die Halbleiterscheibe einer ersten, ein Finish auf beiden Seiten der Halbleiterscheibe zeitgleich erzeugenden Behandlung (Doppelseiten-Finish) unterzogen wird;
b) mindestens eine Beschichtung auf einer Seite der Halbleiterscheibe erzeugt wird; und
c) die Halbleiterscheibe einer zweiten, ein Doppelseiten-Finish erzeugenden Behandlung unterzogen wird.

Die in Schritt a) durchgeführte, ein Doppelseiten-Finisherzeugende Behandlung liefert eine Halbleiterscheibe mit optimaler Scheibengeometrie, das heißt, mit besonders ebenen, planparallelen, glatten und defektfreien Seiten. Die in Schritt a) durchgeführte Behandlung liefert insbesondere eine Scheibengeometrie, die der durch Schritt c) erzielten Geometrie vollständig gleicht. In Schritt b) erfolgt dann die für den jeweiligen Anwendungsfall als notwendig erachtete, einseitige Beschichtung der Halbleiterscheibe. In Schritt c) erhält die Halbleiterscheibe ein zweites Doppelseiten-Finish. Dadurch werden sowohl Beschädigungen auf der unbeschichteten Seite, die gegebenenfalls beim Beschichtungsvorgang entstanden sind, als auch Unebenheiten auf der beschichteten Seite beseitigt. Dabei bleibt die in Schritt a) erzielte, vorteilhafte Scheibengeometrie vollständig erhalten, ohne die Gleichförmigkeit der aufgebrachten Schicht zu beeinträchtigen. Das vorgeschlagene Verfahren läßt sich kostengünstig durchführen, weil vor und nach der Beschichtung gemäß Schritt b) gleichartige Verfahrensschritte vorzunehmen sind und zu deren Durchführung auch gleichartige Bearbeitungswerkzeuge eingesetzt werden können.

Eine Abwandlung des Verfahrens, durch Ersetzen der Schritte a) und c) oder eines dieser Schritte durch Einseiten-Behandlungen, beispielsweise eine Einseiten-Politur oder eine sequentielle Einseiten-Politur, ist aus Kostengründen und wegen der ungünstigeren Ergebnisse einer Einseiten-Behandlung zumindest derzeit nicht zu befürworten.

Hingegen eignet sich zur Durchführung der Schritte a) und c) jede Art der Doppelseiten-Behandlung, insbesondere die Doppelseiten-Politur und der Doppelseiten-Feinschliff. Die Schritte a) und c) müssen darüber hinaus nicht notwendigerweise mit derselben Behandlungsmethode ausgeführt werden. So kann Schritt a) beispielsweise eine Doppelseiten-Politur und Schritt c) einen Doppelseiten-Feinschliff umfassen, oder auf einen Doppelseiten-Feinschliff in Schritt a) eine Doppelseiten-Politur in Schritt c) folgen.

Eine Beschichtung gemäß Schritt b) des Verfahrens umfaßt das Erzeugen einer oder mehrerer Schichten auf einer Seite der Halbleiterscheibe. Die Beschichtung kann nach jedem bekannten Verfahren erfolgen, insbesondere durch Abscheiden einer Schicht oder Erzeugen einer Schicht durch chemische oder physikalische Umwandlung, wie thermische Oxidation oder Dotierung. Nach der Beschichtung sind die Oberflächen der beiden Seiten der Halbleiterscheibe anhand unterschiedlicher chemischer oder physikalischer Eigenschaften unterscheidbar. Beispiele für einseitige Beschichtungen sind das Abscheiden von epitaktischen, polykristallinen oder amorphen Schichten des Halbleitermaterials oder anderer Stoffe auf einer Seite der Halbleiterscheibe oder das Erzeugen einer dünnen Oxidschicht auf einer Seite der Halbleiterscheibe durch oberflächliche Oxidation der Oberfläche dieser Seite mit einem Oxidationsmittel. Es können auch mehrere Beschichtungen nacheinander auf einer Seite der Halbleiterscheibe vorgenommen werden, beispielsweise indem zwei übereinanderliegende epitaktische Schichten mit unterschiedlicher Dotierung abgeschieden werden.

Die Schritte a) und c) können derartig ausgeführt werden, daß in Schritt a) der Betrag der Differenz |Aᵥ-Aᵣ| < A_{d} / 10 und in Schritt c) |Aᵥ-Aᵣ| ≥ A_{d} / 10 ist. Dabei bedeutet |Aᵥ-Aᵣ| den Betrag der Differenz des Materialabtrages von Vorder- und Rückseite der Halbleiterscheibe und A_{d} das arithmetische Mittel des Materialabtrags von Vorder- und Rückseite. Wenn der Betrag der Differenz größer als oder gleich einem Zehntel des durchschnittlichen Materialabtrages ist, so kann man von einer asymmetrischen Behandlung der Seiten mit ausgeprägt unterschiedlichen Materialabträgen auf Vorder- und Rückseite der Halbleiterscheibe sprechen. Ein asymmetrischer Materialabtrag kann beispielsweise aufgrund chemischer oder struktureller Verschiedenheit der beiden Seiten von sich aus, das heißt, ohne verfahrenstechnische Maßnahmen zustande kommen. Man kann ihn auch absichtlich herbeiführen, beispielsweise durch den Einsatz eines Bearbeitungswerkzeuges, dessen Arbeitsflächen mit unterschiedlicher Geschwindigkeit rotieren und/oder mit unterschiedlich abtragenden Poliertüchern oder Disken versehen sind. Solche Maßnahmen können umgekehrt auch ergriffen werden, um chemische oder strukturelle Unterschiede der Seiten zu kompensieren und einen ähnlichen Materialabtrag auf beiden Seiten der Halbleiterscheibe zu erreichen. Ist die angegebene Differenz kleiner als ein Zehntel des durchschnittlichen Materialabtrages, so sind die Materialabträge ähnlich oder identisch und es kann von einer symmetrischen Behandlung der Seiten gesprochen werden. Der Vorteil einer asymmetrische Behandlung der Seiten in Schritt c) ist insbesondere gegeben, wenn in Schritt b) eine Beschichtung mit einer sehr dünnen Schicht gewählt wurde, oder wenn aus anderen Gründen von der erzeugten Schicht nur wenig Material abgetragen werden darf.

Das vorgeschlagene, dreistufige Verfahren eignet sich insbesondere zur Behandlung von Halbleiterscheiben aus Silicium, die von einem Kristall abgetrennt wurden und gegebenenfalls vorgeschliffen oder geläppt worden sind und vorzugsweise auch eine Behandlung mit einem Ätzmittel durchlaufen haben. Grundsätzlich ist das Verfahren jedoch nicht auf die Herstellung einseitig beschichteter Halbleiterscheiben beschränkt. Andere Anwendungsgebiete betreffen die Herstellung einseitig beschichteter Werkstücke aus Glas, Keramik, Metall und Kunststoffen, beispielsweise die Herstellung beschichteter optischer Platten oder elektronischer Speichermedien.

Eine bevorzugte Anwendung des Verfahrens betrifft die Herstellung gebondeter Halbleiterscheiben durch hydrophiles Direkt-Bonden ("hydrophylic direct wafer bonding"). Hierbei werden Paare einseitig mit einer Oxidschicht beschichteter Siliciumscheiben oxidseitig verbunden, so daß eine Sandwichstruktur mit einer zwischen zwei monokristallinen Siliciumschichten begrabenen Oxidschicht entsteht. Beim Direkt-Bonden ist von größter Wichtigkeit, daß die Oxidschichten des Scheibenpaares formschlüssig aufeinandergelegt werden können. Das erfindungsgemäße Verfahren kann Halbleiterscheiben liefern, die diesem Erfordernis voll entsprechen.

## Patentansprüche

1. Verfahren zur Herstellung einer einseitig beschichteten und mit einem Finish versehenen Halbleiterscheibe, **dadurch gekennzeichnet, daß**
a) die Halbleiterscheibe einer ersten, ein Finish auf beiden Seiten der Halbleiterscheibe zeitgleich erzeugenden Behandlung (Doppelseiten-Finish) unterzogen wird;
b) mindestens eine Beschichtung auf einer Seite der Halbleiterscheibe erzeugt wird; und
c) die Halbleiterscheibe einer zweiten, ein Doppelseiten-Finish erzeugenden Behandlung unterzogen wird.

2. Verfahren nach Anspruch 1, **dadurch gekennzeichnet, daß** die Behandlung der Halbleiterscheibe gemäß Schritt a) und Schritt c) aus einer Gruppe von Behandlungsmethoden ausgewählt wird, die die Doppelseiten-Politur und den Doppelseiten-Feinschliff umfaßt.

3. Verfahren nach Anspruch 1, **dadurch gekennzeichnet, daß** die Beschichtung gemäß Schritt b) nach einer Methode erfolgt, die aus einer Gruppe ausgewählt wird, die das Abscheiden einer Schicht auf einer Seite der Halbleiterscheibe und das Erzeugen einer Schicht durch chemische oder physikalische Umwandlung der Oberfläche einer Seite der Halbleiterscheibe umfaßt.

4. Verfahren nach einem der Ansprüche 1 bis 3, **dadurch gekennzeichnet, daß** die Halbleiterscheibe in Schritt a) einer symmetrischen Doppelseiten-Politur und in Schritt c) einer asymmetrischen Doppelseiten-Politur unterzogen wird.

## Claims

1. Method for producing a semiconductor wafer which is coated on one side and is provided with a finish, **characterized in that**
a) the semiconductor wafer is subjected to a first treatment (double-sided finish) which produces a finish on both sides of the semiconductor wafer at the same time;
b) at least one coating is produced on one side of the semiconductor wafer; and
c) the semiconductor wafer is subjected to a second treatment, which produces a double-sided finish.

2. Method according to Claim 1, **characterized in that** the treatment of the semiconductor wafer according to step a) and step c) is selected from a group of treatment methods, which include double-sided polishing and double-sided fine grinding.

3. Method according to Claim 1, **characterized in that** the coating according to step b) is carried out using a method which is selected from a group which includes the deposition of a layer on one side of the semiconductor wafer and the production of a layer by chemical or physical transformation of the surface of one side of the semiconductor wafer.

4. Method according to one of Claims 1 to 3,
**characterized in that** the semiconductor wafer is subjected to symmetrical double-sided polishing in step a), and is subjected to asymmetric double-sided polishing in step c).

## Revendications

1. Méthode pour la fabrication d'une plaquette semi-conductrice à une seule face avec finition miroir, **caractérisée en ce que**
a) la plaquette semi-conductrice est soumise à un premier traitement produisant simultanément une finition miroir (finition miroir double face) des deux côtés de la plaquette semi-conductrice ;
b) au moins un revêtement est produit sur une face de la plaquette semi-conductrice ; et
c) la plaquette semi-conductrice est soumise à un deuxième traitement produisant une finition en miroir double face.

2. Méthode selon la revendication 1, **caractérisée en ce que** le traitement de la plaquette semi-conductrice selon l'étape a) et l'étape c) est choisi dans un groupe de méthodes de traitement qui comprend le polissage sur deux faces et la rectification fine sur deux faces.

3. Méthode selon la revendication 1, **caractérisée en ce que** l'application du revêtement selon l'étape b) est réalisée d'après une méthode qui est choisie dans un groupe qui comprend la déposition d'une couche sur une face de la plaquette semi-conductrice et la génération d'une couche par conversion chimique ou physique de la surface d'une face de la plaquette semi-conductrice.

4. Méthode selon l'une des revendications 1 à 3,
**caractérisée en ce que** la plaquette semi-conductrice est soumise à un polissage symétrique sur deux faces dans l'étape a) et à un polissage asymétrique sur deux faces dans l'étape c).
